# EUROPEAN PATENT APPLICATION

(11) **EP 4 719 030 A1**
(43) Date of publication of application: **01.04.2026**
(21) Application number: 25203580.3
(22) Date of filing: 22.09.2025
(51) Int. Cl.: H10W 40/22, H10W 40/47, H10W 40/00

(54) **INTRA-COOLING DEVICES FOR POWER MODULES, METHODS FOR MANUFACTURING SAME, POWER MODULES AND ELECTRICAL SYSTEMS**

(30) Priority: 29.09.2024 CN 202411370518; 17.09.2025 US 202519331326
(71) Applicant: Shenzhen STS Microelectronics Co., Ltd., Shenzhen 518048 (CN)
(72) Inventor: CHEN, Qiao, Shenzhen, 518040 (CN); ZHENG, Nannan, Shenzhen, 518038 (CN); HUANG, Ming Yue, Shenzhen, 518038 (CN)
(74) Representative: Cabinet Beaumont

(57) **Abstract**

The present disclosure relates to intra-cooling devices for power modules, methods for manufacturing same, power modules and electrical systems. An intra-cooling device for a power module is provided, comprising: a top insulating part formed by integrally fabricating, including: a top cap, and at least one first heat conductor disposed on an inner surface of the top cap and extending in a direction perpendicular to the inner surface of the top cap; and a bottom insulating part formed by integrally fabricating, including: a box composed of a bottom cap and a plurality of sidewalls surrounding the bottom cap, and at least one second heat conductor disposed on an inner surface of the bottom cap and extending in a direction perpendicular to the inner surface of the bottom cap; wherein the top insulating part and the bottom insulating part are assembled together in such a manner that the inner surface of the top cap and the inner surface of the bottom cap face each other, thereby forming a cavity capable of accommodating a cooling liquid.

## Description

### BACKGROUND

### Technical Field

The present disclosure relates to intra-cooling devices for power modules, methods for manufacturing same, power modules and electrical systems.

### Description of the Related Art

Conventional intra-cooling devices for power modules are typically manufactured using a metal material with good thermal conductivity, in which one or more chips are attached to a copper-covered ceramic substrate which is further attached to the intra-cooling device, thereby achieving indirect cooling of the one or more chips. However, such intra-cooling devices have a number of drawbacks, such as poor heat dissipation, complex manufacturing process, high difficulty in electrical isolation, and so on.

Accordingly, there is a need for improved intra-cooling devices for power modules and methods for manufacturing same.

### BRIEF SUMMARY

It is one of the objectives of the present disclosure to provide improved intra-cooling devices for power modules, methods for manufacturing same, improved power modules, and improved electrical systems.

According to an aspect of the present disclosure, there is provided an intra-cooling device for a power module, including: a top insulating part formed by integrally fabricating, including a top cap, and at least one first heat conductor disposed on an inner surface of the top cap and extending in a direction perpendicular to the inner surface of the top cap; and a bottom insulating part formed by integrally fabricating, including a box composed of a bottom cap and a plurality of sidewalls surrounding the bottom cap, and at least one second heat conductor disposed on an inner surface of the bottom cap and extending in a direction perpendicular to the inner surface of the bottom cap; wherein the top insulating part and the bottom insulating part are assembled together in such a manner that the inner surface of the top cap and the inner surface of the bottom cap face each other, thereby forming a cavity capable of accommodating a cooling liquid.

According to one or more embodiments of the present disclosure, the at least one first heat conductor and the at least one second heat conductor are arranged in a staggered manner, such that respective heat conductors are spaced apart from each other by a certain distance in the cavity.

According to one or more embodiments of the present disclosure, the plurality of sidewalls of the bottom insulating part are formed with sealing edges at their locations in contact with the top cap of the top insulating part, the sealing edges being capable of closely mating with edges of the top cap to seal the cavity.

According to one or more embodiments of the present disclosure, the intra-cooling device further includes: a liquid inlet formed in the top cap of the top insulating part, wherein the cooling liquid flows into the cavity through the liquid inlet; and a liquid outlet formed in the top cap of the top insulating part or in the bottom cap of the bottom insulating part, wherein the cooling liquid flows out of the cavity through the liquid outlet.

According to one or more embodiments of the present disclosure, the intra-cooling device further comprises one or both of: a first metal layer disposed on an outer surface of the top cap of the top insulating part for attaching a first chip; and a second metal layer disposed on an outer surface of the bottom cap of the bottom insulating part for attaching a second chip.

According to one or more embodiments of the present disclosure, the at least one first heat conductor and the at least one second heat conductor include one or more of: a cylinder heat conductor, an elliptic cylinder heat conductor, a rectangular cylinder heat conductor, a regular polygonal cylinder heat conductor, an irregular cylinder heat conductor and a cone heat conductor; the attaching includes bonding together by sintering or welding using an electrically and/or thermally conductive material; the first chip and/or the second chip include a power chip; the first metal layer is formed on the outer surface of the top cap of the top insulating part by sintering, brazing, soldering or curing; and/or the second metal layer is formed on the outer surface of the bottom cap of the bottom insulating part by sintering, brazing, soldering or curing.

According to another aspect of the present disclosure, there is provided a power module including the intra-cooling device as described above.

According to one or more embodiments of the present disclosure, the intra-cooling device includes a first metal layer disposed on an outer surface of the top cap of the top insulating part and a second metal layer disposed on an outer surface of the bottom cap of the bottom insulating part. The power module further includes: a first chip attached on the first metal layer, the first chip being electrically coupled by the first metal layer and at least one of a conductive pillar, a conductive clip or a conductive wire; and a second chip attached on the second metal layer, the second chip being electrically coupled by the second metal layer and at least one of the conductive pillar, the conductive clip or the conductive wire; wherein the first metal layer and the second metal layer are further attached to leads extending beyond the intra-cooling device.

According to still another aspect of the present disclosure, there is provided an electrical system comprising the power module as described above.

According to a further aspect of the present disclosure, there is provided a manufacturing method for an intra-cooling device for a power module, comprising the following steps: forming a top insulating part by integrally fabricating, including a top cap, and at least one first heat conductor disposed on an inner surface of the top cap and extending in a direction perpendicular to the inner surface of the top cap; forming a bottom insulating part by integrally fabricating, including a box composed of a bottom cap and a plurality of sidewalls surrounding the bottom cap, and at least one second heat conductor disposed on an inner surface of the bottom cap and extending in a direction perpendicular to the inner surface of the bottom cap; and assembling the top insulating part and the bottom insulating part together in such a manner that the inner surface of the top cap and the inner surface of the bottom cap face each other, thereby forming a cavity capable of accommodating a cooling liquid.

According to one or more embodiments of the present disclosure, the manufacturing method further includes performing, before assembling the top insulating part and the bottom insulating part together, one or both of the following steps: forming a first metal material layer on an outer surface of the top cap of the top insulating part and shaping the first metal material layer, thereby forming a first metal layer for attaching a first chip; and forming a second metal material layer on an outer surface of the bottom cap of the bottom insulating part and shaping the second metal material layer, thereby forming a second metal layer for attaching a second chip.

According to one or more embodiments of the present disclosure, the manufacturing method further includes performing, before assembling the top insulating part and the bottom insulating part together, the following steps: forming a liquid inlet and a liquid outlet in the first metal layer and the top cap of the top insulating part; or, forming a liquid inlet in the first metal layer and the top cap of the top insulating part, and forming a liquid outlet in the bottom cap of the bottom insulating part, wherein the cooling liquid flows into the cavity through the liquid inlet, and flows out of the cavity through the liquid outlet.

According to one or more embodiments of the present disclosure, the at least one first heat conductor and the at least one second heat conductor are arranged in a staggered manner, such that respective heat conductors are spaced apart from each other by a certain distance in the cavity.

According to one or more embodiments of the present disclosure, the plurality of sidewalls of the bottom insulating part are formed with sealing edges at their locations in contact with the top cap of the top insulating part, the sealing edges being capable of closely mating with edges of the top cap to seal the cavity.

According to one or more embodiments of the present disclosure, the at least one first heat conductor and the at least one second heat conductor include one or more of: a cylinder heat conductor, an elliptic cylinder heat conductor, a rectangular cylinder heat conductor, a regular polygonal cylinder heat conductor, an irregular cylinder heat conductor and a cone heat conductor; the attaching comprises bonding together by sintering or welding using an electrically and/or thermally conductive material; the first chip and/or the second chip comprise a power chip; the first metal material layer is formed on the outer surface of the top cap of the top insulating part by sintering, brazing, soldering or curing; and/or the second metal material layer is formed on the outer surface of the bottom cap of the bottom insulating part by sintering, brazing, soldering or curing.

Other features and advantages of the present disclosure will become clearer from the following detailed description of illustrative embodiments of the present disclosure with reference to the accompanying drawings.

### BRIEF DESCRIPTION OF THE SEVERAL VIEWS OF THE DRAWINGS

The accompanying drawings, which form a part of the specification, illustrate some embodiments of the present disclosure and together with the specification, serve to explain the principles of the present disclosure.

The present disclosure can be more clearly understood from the following detailed description with reference to the accompanying drawings, in which:
FIG. 1A schematically illustrates a cross-sectional view of an intra-cooling device for a power module according to an embodiment of the present disclosure;
FIG. 1B schematically illustrates a cross-sectional view of a top insulating part of the intra-cooling device in FIG. 1A;
FIG. 1C schematically illustrates a cross-sectional view of a bottom insulating part of the intra-cooling device in FIG. 1A;
FIG. 2A schematically illustrates a cross-sectional view of an intra-cooling device with a liquid inlet and a liquid outlet located on the same side according to an embodiment of the present disclosure;
FIG. 2B schematically illustrates a cross-sectional view of an intra-cooling device with a liquid inlet and a liquid outlet located on opposite sides according to an embodiment of the present disclosure;
FIG. 3A schematically illustrates a structural schematic diagram of a power module including an intra-cooling device according to an embodiment of the present disclosure;
FIG. 3B illustrates a structural schematic diagram of the power module of FIG. 3A before packaged;
FIG. 3C illustrates a structural schematic diagram of a side view of the power module of FIG. 3A before packaged;
FIG. 4 illustrates an exemplary flow diagram of a manufacturing method for an intra-cooling device for a power module according to an embodiment of the present disclosure;
FIGS. 5A-5G schematically illustrate structural schematic diagrams of devices corresponding to some of the steps of the method shown in FIG.4.

Note that in the embodiments described below, the same reference number is sometimes shared between different drawings to denote the same portions or portions having the same functions, and a repetitive description thereof will be omitted. In some cases, similar items are denoted using similar reference numbers and letters, and thus, once a certain item is defined in a drawing, it does not need to be further discussed in subsequent drawings.

For ease of understanding, positions, sizes, ranges, and the like of the various structures shown in the drawings and the like sometimes do not indicate actual positions, sizes, ranges, and the like. Therefore, the present disclosure is not limited to the positions, sizes, ranges, and the like disclosed in the drawings and the like.

### DETAILED DESCRIPTION

In conventional power modules, one or more chips are attached to a copper-covered ceramic substrate which is further attached to an intra-cooling device made of a metallic material, thereby achieving indirect cooling of the one or more chips. After research, inventors of the present application found that such intra-cooling devices and power modules have many drawbacks to be improved.

First, a heat dissipation path from the one or more chips to the copper-covered ceramic substrate and then to the intra-cooling device includes a plurality of alternating metal material layers and ceramic material layers, and there are also a plurality of attachment material layers (*e.g.,* an attachment material layer for attaching the substrate to the intra-cooling device, an attachment material layer for attaching the chip to the substrate, etc.) in the heat dissipation path, resulting in lengthy heat dissipation path and low heat dissipation efficiency. Further, assembling the one or more chips, the copper-covered ceramic substrate and the intra-cooling device together requires many processing steps, which will result in increased manufacturing time and cost of the power module. Furthermore, the one or more chips needs to be completely electrically insulated from the intra-cooling device. Although the intra-cooling device made of metal material can make full use of the thermal conductivity of the metal material, it cannot avoid the difficulty in electrical isolation due to the electrical conductivity of the metal material.

In view of the above problems, inventors of the present application propose completely new technical solutions for intra-cooling devices for power modules, methods for manufacturing same, and the corresponding power modules, so as to overcome some or all of the above drawbacks.

Some embodiments of the present disclosure will be described in detail below with reference to the accompanying drawings. The following description of at least one exemplary embodiment is merely illustrative in fact and is in no way intended to limit the present disclosure and its applications or uses. That is to say, the structures and methods herein are shown in an exemplary manner to illustrate different embodiments of the structures and methods in the present disclosure. However, those skilled in the art will understand that they merely illustrate exemplary, not exhaustive, manners in which the present disclosure can be implemented.

In all the examples shown and discussed here, the relative arrangement, numerical expressions and numerical values of components and steps set forth in these embodiments do not limit the scope of the present disclosure, unless otherwise specified. In all examples shown and discussed herein, any specific values should be interpreted as exemplary only and not as a limitation. Therefore, other examples of exemplary embodiments can have different values. Furthermore, the drawings are not necessarily drawn to scale, and some features may be exaggerated to show details of specific components.

The technologies, methods and devices known to those skilled in the relevant fields may not be discussed in detail, but in appropriate cases, they should be regarded as part of the granted specification.

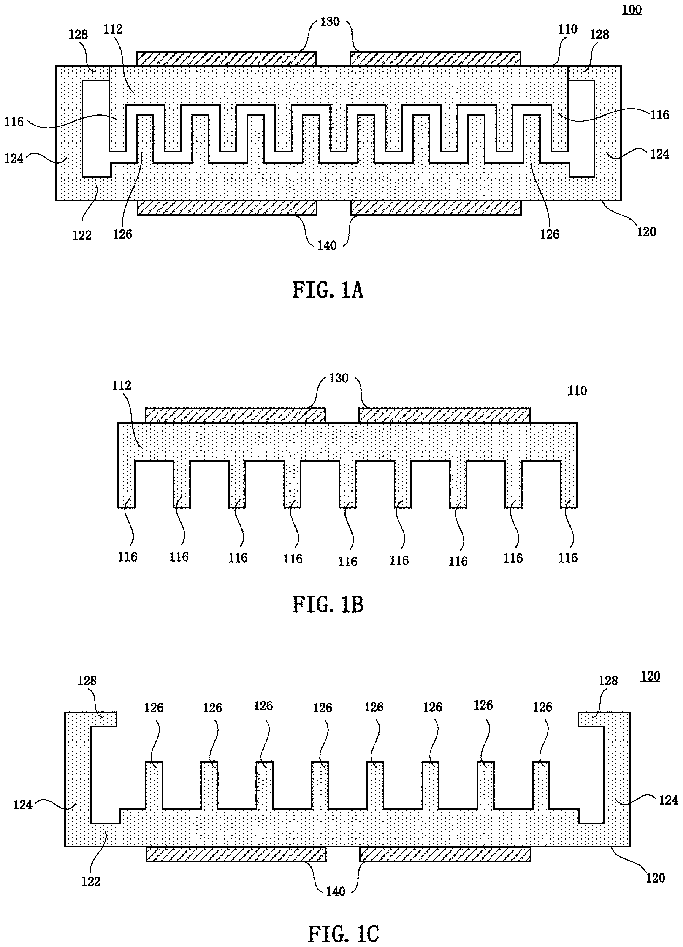

FIG. 1A schematically illustrates a cross-sectional view of an intra-cooling device 100 for a power module according to an embodiment of the present disclosure.

As shown in FIG. 1A, the intra-cooling device 110 according to the embodiment of the present disclosure may comprise: a top insulating part 110 formed by integrally fabricating and a bottom insulating part 120 formed by integrally fabricating.

FIG. 1B schematically illustrates a cross-sectional view of a top insulating part 110 of the intra-cooling device 100 in FIG. 1A. As shown in FIG. 1B, the top insulating part 110 may include a top cap 112 and at least one first heat conductor 116. The at least one first heat conductor 116 is disposed on an inner surface of the top cap 112 and extending in a direction substantially perpendicular, or otherwise transverse to the inner surface of the top cap 112. A plurality of the first heat conductors may be a plurality of fingers or cylindrical pillars that extend away from a base or inner surface of the top cap 112.

FIG. 1C schematically illustrates a cross-sectional view of a bottom insulating part 120 of the intra-cooling device 100 in FIG. 1A. As shown in FIG. 1C, the bottom insulating part 120 may include: a box composed of a bottom cap 112 and a plurality of sidewalls 124 surrounding the bottom cap, and at least one second heat conductor 126. The at least one second heat conductor 126 is disposed on an inner surface of the bottom cap 122 and extends in a direction perpendicular to the inner surface of the bottom cap 122. The first heat conductor 116 and the second heat conductor 126 can increase a contact area between the cooling fluid and the intra-cooling device 100 to promote more sufficient heat exchange therebetween, thereby improving the heat dissipation effect of the cooling device. The top insulating part 110 and the bottom insulating part 120 may be made of any suitable insulating material, which may include, for example, an insulating ceramic material or the like. A plurality of the second heat conductors may be a plurality of fingers or cylindrical pillars that extend away from a base or inner surface of the bottom cap 122.

With continued reference to FIG.1A, in the intra-cooling device 100, the top insulating part 110 and the bottom insulating part 120 may be assembled together in such a manner that the inner surface of the top cap 112 and the inner surface of the bottom cap 122 face each other, thereby forming a cavity capable of accommodating a cooling liquid. In the cavity, the at least one first heat conductor 116 and the at least one second heat conductor 126 may be arranged in a staggered manner with respect to each other, such that respective heat conductors are spaced apart from each other by a certain distance in the cavity. The staggered heat conductors enable the cooling liquid to flow in the tortuous cavity and to be in sufficient contact with respective heat conductors, thereby enabling the cooling liquid to sufficiently absorb heat from the heat conductors to improve heat dissipation efficiency.

Those skilled in the art will appreciate that, while the number, shape, and arrangement of the first and second heat conductors 116 and 126 are illustrated in FIGS. 1A-1C, this is not intended to be limiting in any way. First, the number of the first heat conductors 116 and the number of the second heat conductors 126 can be arbitrarily set according to application requirements. Further, the first and second heat conductors 116 and 126 may take any shape, particularly a shape suitable for increasing a contact area with the cooling liquid, including but not limited to one or more of: a cylinder heat conductor, an elliptical cylinder heat conductor, a rectangular cylinder heat conductor, a regular polygonal cylinder heat conductor, an irregular cylinder heat conductor, a cone heat conductor, and the like. Furthermore, the first and second heat conductors 116 and 126 may be arranged in any staggered manner with respect to one another, particularly arrangements adapted to promote the flow of the cooling fluid and the sufficient contact of the cooling fluid with the heat conductors.

In some embodiments, the plurality of sidewalls 124 of the bottom insulating part 120 may be formed with sealing edges 128 at locations where the plurality of sidewalls 124 are in contact with the top cap 112 of the top insulating part 110. The sealing edges 128 project relative to the sidewalls 124 to enable close mating with edges of the top cap 112 to seal the cavity. When the sealing edges 128 are mated with the edges of the top cap 112, a waterproof adhesive layer may also be applied at a seam of the two, thereby adequately sealing the cavity. The provision of the sealing edges 128 allows an area of the seam region between the top insulating part and the bottom insulating part to be greatly reduced relative to the conventional intra-cooling devices, thereby improving the sealing performance of the intra-cooling device of the present application.

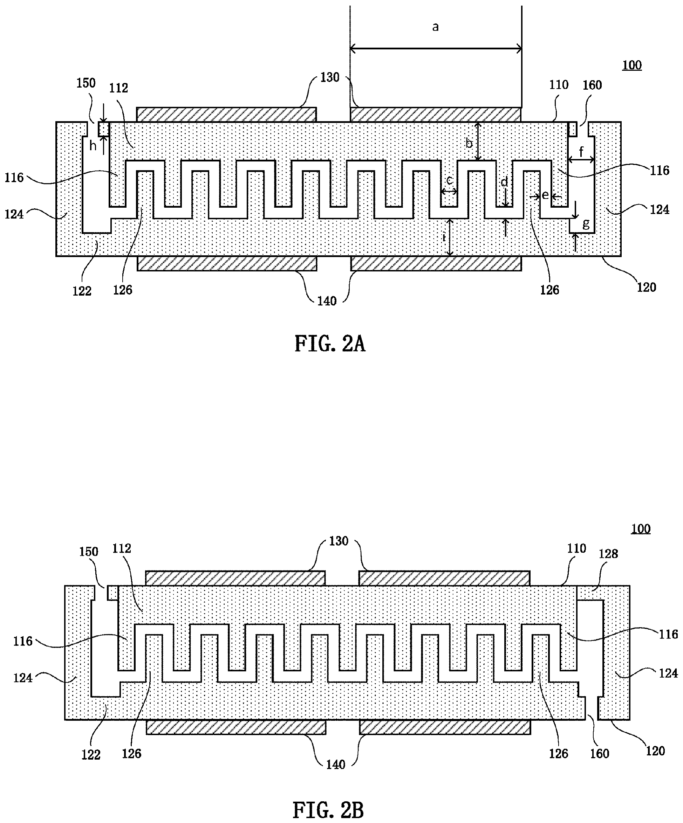

The intra-cooling device 100 according to an embodiment of the present disclosure may further include a liquid inlet and a liquid outlet, and the cooling liquid flows into the cavity through the liquid inlet and flows out of the cavity through the liquid outlet. The liquid inlet and the liquid outlet may be disposed on the top surface and/or bottom surface of the intra-cooling device 100 as needed. For example, FIG. 2A schematically illustrates a cross-sectional view of the intra-cooling apparatus 100 with the liquid inlet and the liquid outlet located on the same side according to an embodiment of the present disclosure, where both the liquid inlet 150 and the liquid outlet 160 are formed in the top cap 112 of the top insulating part 110. The first metal layer 130 may have a first length in a first direction "a". The first length "a" is longer than at least six consecutive ones of the first and second heat conductors 116 and 126, along the first direction. Said differently, there are a plurality of heat conductors 116 that extend from the insulating part 110 in a second direction that is transverse to the first direction that are within the dimensions of the first length of the first metal layer 130.

The top cap 112 and the bottom cap 122 have a thickness "b" that extends in the second direction, the thickness "b" being wider than a thickness of the first heat conductor "c," which extends in the first direction in Figure 2A. The second heat conductors also have substantially the same thickness "c" as the first heat conductors. Spaces "d" and "e" are substantially the same to each other and are closer to the dimension of "c" than a dimension "f". The dimension "f" extends in the first direction and may be wider than that of "c" or "e." Step "g," which has a dimension in the second direction is configured to be smaller than the dimension of "f" in a way that "g" provides additional surface to expedite heat dissipation. A thickness "h" in the second direction is thicker than "c." For another example, FIG. 2B schematically illustrates a cross-sectional view of the intra-cooling apparatus 100 with the liquid inlet and the liquid outlet located on the opposite sides according to an embodiment of the present disclosure, where the inlet port 150 is formed in the top cap 112 of the top insulating part 110 and the outlet port 160 is formed in the bottom cap 122 of the bottom insulating part 120.

With continued reference to FIG. 1A, the intra-cooling device 100 according to an embodiment of the present disclosure may further include: a first metal layer 130 disposed on an outer surface of the top cap 112 of the top insulating part 110, for attaching a first chip (not shown in the figure); and/or a second metal layer 140 disposed on an outer surface of the bottom cap 122 of the bottom insulating part 120, for attaching a second chip (not shown in the figure). In some embodiments, the intra-cooling device 100 may include only the first metal layer 130. In some other embodiments, the intra-cooling device 100 may include only the second metal layer 140. In still some other embodiments, the intra-cooling device 100 may include both the first metal layer 130 and the second metal layer 140.

In embodiments of the present disclosure, "attaching" may refer to, for example, bonding with one another by an electrically and/or thermally conductive material, and may be performed by using processes such as sintering or welding. For example, one or more first chips (not shown) may be attached to the first metal layer 130 by an electrically and thermally conductive attachment material layer (not shown). For another example, one or more second chips (not shown) may be attached to the second metal layer 140 by an electrically and thermally conductive attachment material layer (not shown).

In some embodiments, the first chip and/or the second chip may include a power chip.

In some embodiments, the first metal layer 130 may be formed on the outer surface of the top cap 112 of the top insulating part 110 by sintering, brazing, soldering, or curing; and/or, the second metal layer 140 may be formed on the outer surface of the bottom cap 122 of the bottom insulating part 120 by sintering, brazing, soldering, or curing.

In some embodiments, the arrangement of the first heat conductors 116 and the second heat conductors 126 may be placed in a centrally symmetric manner over the intra-cooling device 100, respectively.

In some embodiments, the arrangement of the first metal layer 130 and the second metal layer 140 may be placed in a centrally symmetric manner over the intra-cooling device 100, respectively.

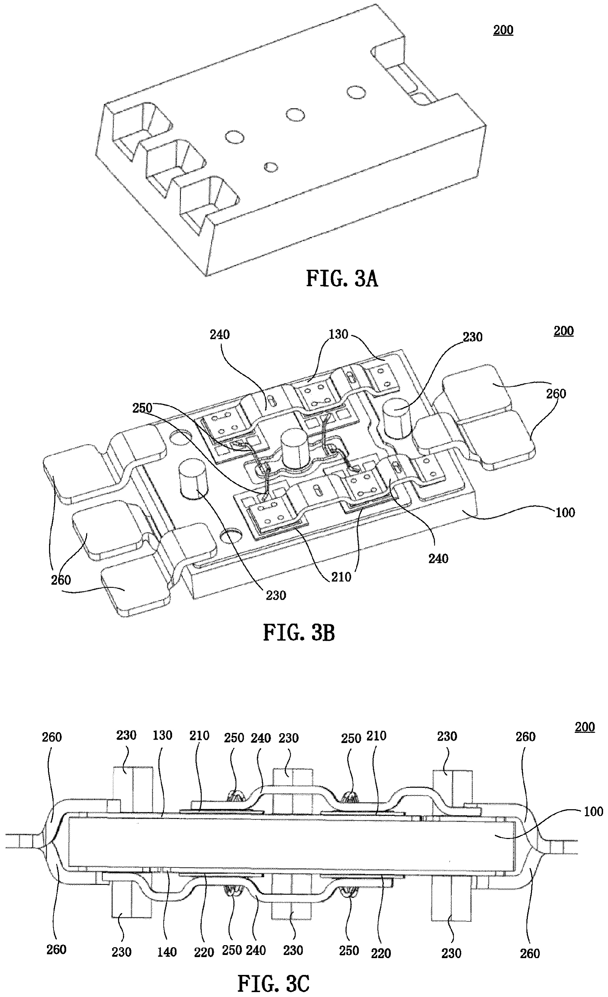

FIG. 3A schematically illustrates a structural schematic diagram of a power module 200 including an intra-cooling device, according to an embodiment of the present disclosure; FIG. 3B illustrates a structural schematic diagram of the power module 200 of FIG. 3A before packaged; and FIG. 3C illustrates a structural schematic diagram of a side view of the power module 200 of FIG. 3A before packaged. Compared to FIG. 3A, various components of the power module 200 in FIGS. 3B and 3C are not yet covered by an encapsulation material layer, so that the various components therein are clearly shown.

As shown in FIGS. 3B and 3C, the power module 200 according to an embodiment of the present application may include the intra-cooling device 100 as shown in FIG. 1A. The intra-cooling device 100 may comprise a first metal layer 130 disposed on an outer surface of the top cap of the top insulating part and a second metal layer 140 disposed on an outer surface of the bottom cap of the bottom insulating part. The power module 200 may further include: one or more first chips 210 attached on the first metal layer 130 and one or more second chips 220 attached on the second metal layer 140. The first chip 210 may be electrically coupled by the first metal layer 130 and at least one of a conductive pillar 230, a conductive clip 240 or a conductive wire 250. Likewise, the second chip 220 may be electrically coupled by the second metal layer 140 and at least one of a conductive pillar 230, a conductive clip 240 or a conductive wire 250. The first chips 120 and the second chips 220 may be arranged in a centrally symmetric manner over the intra-cooling device 100, respectively. The first metal layer 130 and the second metal layer 140 may be further attached to one or more leads 260 extending beyond the intra-cooling device 100. In preferred embodiments, the conductive clip 240 may include a copper clip or the like.

It will be understood by those skilled in the art that, although the number, distribution, shape and size of the first chips 210, the second chips 220, the conductive pillars 230, the conductive clips 240, the conductive wires 250, the leads 260 and the like are schematically illustrated in FIGS. 3B and 3C, this is merely for the purpose of showing the various components as fully as possible in the same set of figures and is not intended to be limiting in any way. The power modules according to the embodiment of the present disclosure may include any number, any distribution, any shape, and any size of the above-described components.

The intra-cooling device 100 and the power module 200 according to the embodiments of the present disclosure achieve many improvements over the conventional internal pooling devices and power modules.

First, the intra-cooling devices of the present application are remarkably improved in heat dissipation efficiency. Conventional intra-cooling devices are typically manufactured using a metal material, and the chips need to be mounted over the intra-cooling device indirectly through a copper-covered ceramic substrate (the substrate is composed of a ceramic material and copper layers attached on both sides thereof). In contrast, the intra-cooling device of the present application innovatively uses the top and bottom insulating parts formed by an integrally fabricating technique and then assembled, so that the chips can be directly attached to the intra-cooling device through the metal layers disposed on outer surfaces of the top and bottom insulating parts. On one hand, the design shortens a heat dissipation path, so that heat generated by the chips can be more directly conducted to the intra-cooling device. On the other hand, switching between different material layers is reduced, thereby significantly improving the cooling efficiency of the intra-cooling device. In addition, directly attaching the chips to the intra-cooling device also simplifies assembly processing steps of various components, thereby optimizing the manufacturing flow of the power modules and reducing the production cost.

Furthermore, the power modules using the intra-cooling devices of the present application are more compact in area and volume than the conventional power modules, promoting miniaturization of the power modules. On the one hand, the improvement of the cooling efficiency enables the intra-cooling device of the present application to attach a chip with a larger area on the same unit cooling area, thereby reducing the whole area of the power module. On the other hand, the top insulating part and the bottom insulating part not only take on the cooling function, but also can be used as the attachment substrate of the chip, so that the use of a copper-covered ceramic substrate is eliminated, which obviously decreases the thickness of the power module, and further promotes the miniaturization process of the power module. In addition, the liquid inlet and the liquid outlet of the intra-cooling device (and the corresponding power module) of the present application can be arranged on only the upper surface or on both the upper and lower surfaces, so that the side surfaces of a plurality of power modules can be tightly attached, thereby achieving more compact integration or installation, further reducing a product volume.

Moreover, the intra-cooling device of the present application has an excellent sealing effect and electric isolation performance, and is not easy to corrode or erode. As described above, the intra-cooling device of the present application is composed of the top and bottom insulating parts formed by integrally fabricating respectively, and the seam region of the two integrally-fabricated components is greatly reduced compared with that of the conventional intra-cooling device, thereby realizing better sealing effect on the cooling liquid. Further, since the intra-cooling device of the present application is made of an insulating material (e.g., an insulating ceramic material), it has not only a good electrical isolation effect, but also excellent corrosion and erosion resistance.

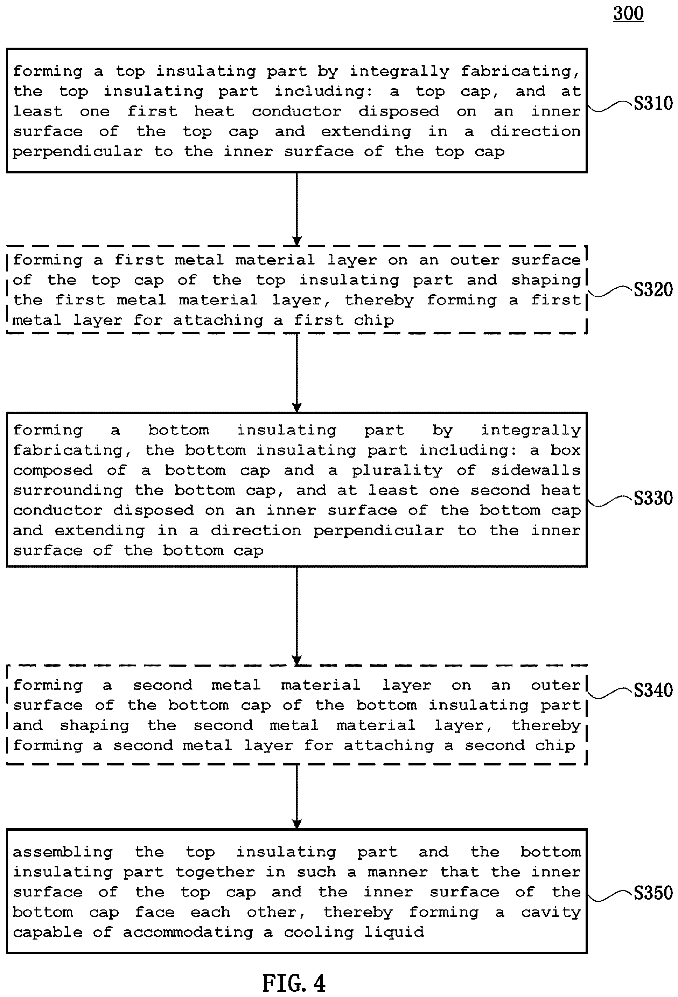

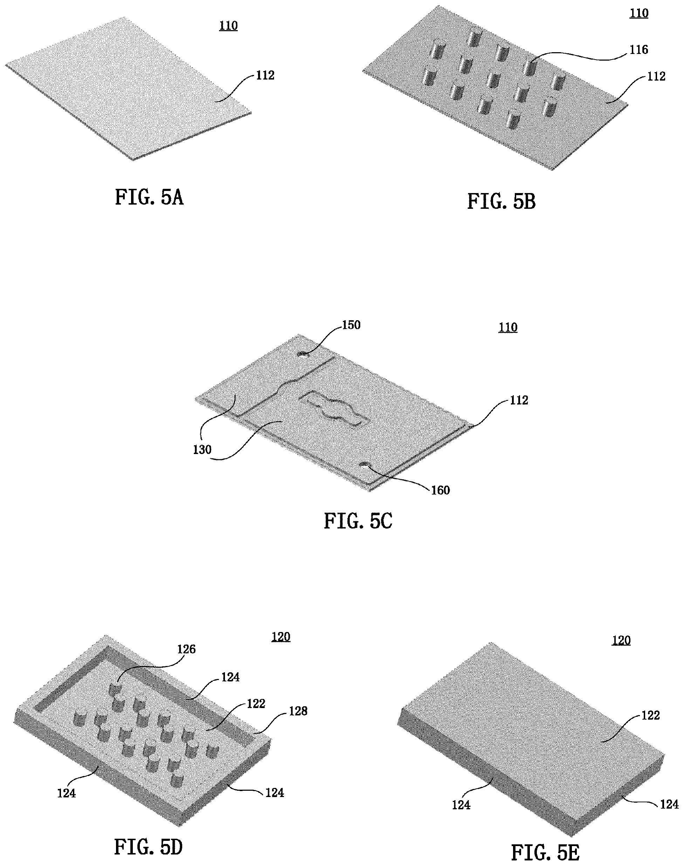

The manufacturing method for an intra-cooling device for a power module according to an embodiment of the present disclosure will be described below with reference to FIGS. 4 and 5A-5G. FIG. 4 illustrates an exemplary flow diagram of a manufacturing method 300 for an intra-cooling device for a power module according to an embodiment of the present disclosure; and FIGS. 5A-5G schematically illustrate structural schematic diagrams of the devices corresponding to some of the steps of the method shown in FIG.4. Those skilled in the art will appreciate that, the manufacturing method 300 for an intra-cooling device for a power module described in conjunction with FIGS. 4 and 5A-5G may be used to manufacture the intra-cooling device 100 described in accordance with the foregoing embodiments of the present disclosure, and thus the foregoing corresponding description for the power module 200 applies here as well.

As shown in FIG. 4, the manufacturing method 300 for an intra-cooling device for a power module according to an embodiment of the present disclosure may include steps S310, S330, and S350.

At step S310, the top insulating part 110 is formed by integrally fabricating. FIGS. 5A and 5B illustrate structural schematic diagrams of a top view and a bottom view of the top insulating part 110, respectively. As shown in FIGS. 5A and 5B, the top insulating part 110 may include: a top cap 112; and a plurality of first heat conductors 116 disposed on the inner surface of the top cap 112 and extending in a direction perpendicular to the inner surface of the top cap 112.

At step S330, the bottom insulating part 120 is formed by integrally fabricating. FIGS. 5D and 5E respectively illustrate structural schematic diagrams of a top view and a bottom view of the bottom insulating part 120. As shown in FIGS. 5D and 5E, the bottom insulating part 120 may include: a box composed of a bottom cap 122 and a plurality of sidewalls 124 surrounding the bottom cap 122; and a plurality of second heat conductors 126 disposed on an inner surface of the bottom cap 122 and extending in a direction perpendicular to the inner surface of the bottom cap 122.

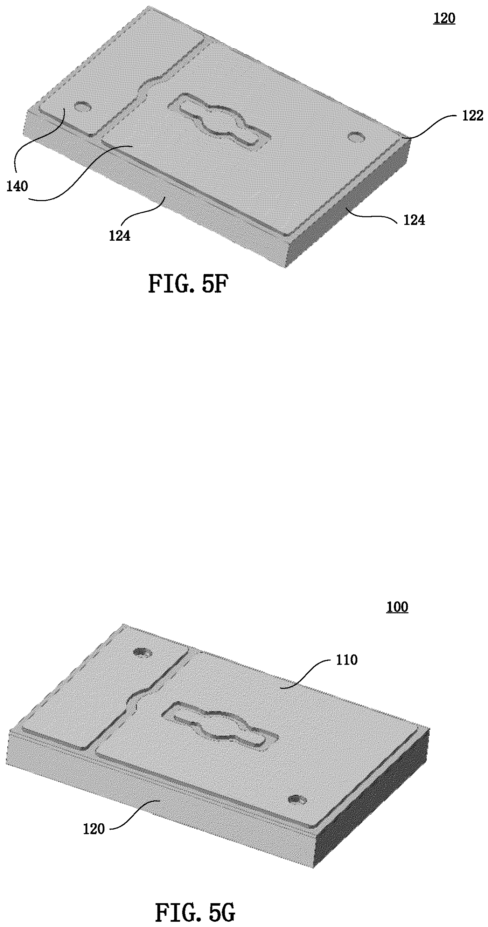

At step S350, the top insulating part 110 and the bottom insulating part 120 are assembled together in such a manner that the inner surface of the top cap 112 and the inner surface of the bottom cap 122 face each other, thereby a cavity capable of accommodating a cooling liquid. Fig. 5G illustrates a structural schematic view of the assembled intra-cooling device 100.

In some embodiments, the manufacturing method 300 for an intra-cooling device for a power module may also optionally include performing one or both of steps S320 and S340, prior to assembling the top and bottom insulating parts together (step S350).

As shown in FIG. 4, at step S320, a first metal material layer is formed on an outer surface of the top cap 112 of the top insulating part 110 and is shaped to form the first metal layer 130 for attaching a first chip. FIG. 5C illustrates a structural schematic diagram of a top view of the top insulating part 110 with the first metal layer 130.

In some embodiments, the first metal material layer may be formed on the outer surface of the top cap 112 of the top insulating part 110 by sintering, brazing, soldering, or curing.

At step S340, a second metal material layer is formed on an outer surface of the bottom cap 122 of the bottom insulating part 120 and shaped to form a second metal layer 140 for attaching a second chip. FIG. 5F illustrates a structural schematic diagram of a bottom view of the bottom insulating part 120 with the second metal layer 140.

In some embodiments, the second metal material layer is formed on the outer surface of the bottom cap of the bottom insulating part by sintering, brazing, soldering or curing.

In some embodiments, the first chip and/or the second chip may include a power chip.

The steps S320 and S340 shown in dashed boxes in FIG. 4 are optional steps, that is, the method may or may not include these steps. For example, the manufacturing method 300 for an intra-cooling device for a power module may comprise only the step S320 without the step S340, may comprise only the step S340 without the step S320, or may comprise both the step S320 and the step S340.

Those skilled in the art will appreciate that, while the flow diagram of FIG. 4 depicts a particular order of execution of steps, the order may be altered without departing from the scope of the present disclosure. Some of the depicted steps may be performed in parallel or in a different order that does not substantively affect the functionality of the process. For example, the bottom insulating part may be formed (step S330) before forming the top insulating part (step S310), or forming the top insulating part (step S310) and forming the bottom insulating part (step S330) may be performed in parallel, and so on. For another example, forming the first metal layer (step S320) and forming the second metal layer (step S340) may be performed after forming the top insulating part (step S310) and forming the bottom insulating part (step S330), or the two steps of forming the top insulating part (step S310) and forming the first metal layer (step S320) may be performed in parallel with the two steps of forming the bottom insulating part (step S330) and forming the second metal layer (step S340), and so on.

In some embodiments, the plurality of first heat conductors 116 and the plurality of second heat conductors 126 may be arranged in a staggered manner, such that respective heat conductors are spaced apart from each other by a certain distance in the cavity.

In some embodiments, as shown in FIG. 5D, the plurality of sidewalls 124 of the bottom insulating part 120 are formed with sealing edges 128 at their locations in contact with the top cap of the top insulating part, the sealing edges 128 being capable of closely mating with edges of the top cap to seal the cavity.

In some embodiments, the manufacturing method 300 for an intra-cooling device for a power module may further comprise: forming a liquid inlet and a liquid outlet in the first metal layer and the top cap of the top insulating part; or, forming a liquid inlet in the first metal layer and the top cap of the top insulating part, and forming a liquid outlet in the second metal layer and the bottom cap of the bottom insulating part. The cooling liquid flows into the cavity through the liquid inlet, and flows out of the cavity through the liquid outlet. FIG. 5C illustrates an embodiment in which both the liquid inlet 150 and the liquid outlet 160 are formed in the first metal layer 130 and the top cap 112 of the top insulating part.

In some embodiments, the first heat conductor 116 and the second heat conductor 126 include one or more of: a cylinder heat conductor, an elliptic cylinder heat conductor, a rectangular cylinder heat conductor, a regular polygonal cylinder heat conductor, an irregular cylinder heat conductor or a cone heat conductor, etc.

In some embodiments, the assembly of the first heat conductor 116, the second heat conductor, the first metal layer 130, the second metal layer 140, the first chip 210, and the second chip 220 may be configured to be arranged in a centrally symmetric manner over the intra-cooling device 100, respectively.

The present disclosure also contemplates an electrical system that may comprise one or more power modules according to any of the embodiments of the present disclosure. By way of example, the electrical system may comprise, for example, an inverter, a new energy vehicle, a wind power system, a solar power generation system, an energy storage system, and any other devices or systems that need to use the power module of the present disclosure.

As used herein, the word "chip" includes, but is not limited to, a die.

Terms "front," "back," "top," "bottom," "above," "below," and the like in the description and the claims, if any, are used for descriptive purposes and not necessarily for describing permanent relative positions. It should be understood that the terms so used are interchangeable where appropriate such that some embodiments of the present disclosure described herein, for example, can operate in other orientations different from those illustrated herein or otherwise described.

As used herein, a term "exemplary" means "serving as an example, instance, or illustration," and not as a "model" that is to be reproduced exactly. Any implementation exemplarily described herein is not necessarily to be construed as preferred or advantageous over other implementations. Furthermore, the present disclosure is not limited by any expressed or implied theory presented in the above TECHNICAL FIELD, BACKGROUND, SUMMARY, or DETAILED DESCRIPTION.

As used herein, a term "substantially" or "about" means encompassing any minor variations caused by imperfections in design or manufacturing, tolerances of components or elements, environmental effects and/or other factors. The term "substantially" or "about" also allows for differences from a perfect or ideal situation caused by parasitic effect, noise, and other practical considerations that may exist in a practical implementation.

In addition, the foregoing description may mention elements or nodes or features that are "connected" or "coupled" together. As used herein, unless expressly stated otherwise, "connected" means that one element/node/feature is directly connected with (or directly communicates with) another element/node/feature in an electrical, mechanical, logical, or other manner. Similarly, unless expressly stated otherwise, "coupled" means that one element/node/feature may be directly or indirectly connected with another element/node/feature in a mechanical, electrical, logical or other manner, to allow interaction, even if the two elements are not directly connected. That is, "coupled" is intended to include direct and indirect connections of elements or other features, including connection using one or more intermediate elements.

In addition, for reference purposes only, similar terms such as "first" and "second" can also be used herein, and thus are not intended to be limiting. For example, unless clearly indicated by the context, the terms "first," "second" and other such numerical terms involving structures or elements do not imply a sequence or order.

It should be further understood that a term "comprise/include," when used herein, specifies the presence of stated features, wholes, steps, operations, units, and/or components, but does not preclude the presence or addition of one or more other features, wholes, steps, operations, units, components, and/or combinations thereof.

In the present disclosure, a term "provide" is used broadly to encompass all ways of obtaining an object, and thus "providing an object" includes, but is not limited to, "purchasing," "preparing / manufacturing," "arranging / setting," "installing / assembling," and/or "ordering" the object, and so on.

Those skilled in the art should realize that boundaries between the above operations are merely illustrative. Multiple operations can be combined into a single operation, a single operation can be distributed in additional operations, and the execution of the operations can be at least partially overlapped in time. Moreover, alternative embodiments can include multiple instances of specific operations, and the order of the operations may be altered in various other embodiments. However, other modifications, variations, and alternatives are also possible. Accordingly, this description and the accompanying drawings should be regarded as illustrative rather than restrictive.

Although some specific embodiments of the present disclosure have been described in detail through examples, it should be understood by those skilled in the art that the above examples are for illustration only and are not intended to limit the scope of the present disclosure. The embodiments disclosed herein can be combined arbitrarily without departing from the spirit and scope of the present disclosure. Those skilled in the art should also appreciate that various modifications can be made to the embodiments without departing from the scope and spirit of the present disclosure. The scope of the present disclosure is defined by the appended claims.

An intra-cooling device for a power module is provided, comprising: a top insulating part formed by integrally fabricating, comprising: a top cap; and at least one first heat conductor disposed on an inner surface of the top cap and extending in a direction perpendicular to the inner surface of the top cap; and a bottom insulating part formed by integrally fabricating, comprising: a box composed of a bottom cap and a plurality of sidewalls surrounding the bottom cap; and at least one second heat conductor disposed on an inner surface of the bottom cap and extending in a direction perpendicular to the inner surface of the bottom cap; wherein the top insulating part and the bottom insulating part are assembled together in such a manner that the inner surface of the top cap and the inner surface of the bottom cap face each other, thereby forming a cavity capable of accommodating a cooling liquid.

The at least one first heat conductor and the at least one second heat conductor are arranged in a staggered manner, such that respective heat conductors are spaced apart from each other by a certain distance in the cavity.

The plurality of sidewalls of the bottom insulating part are formed with sealing edges at their locations in contact with the top cap of the top insulating part, the sealing edges being capable of closely mating with edges of the top cap to seal the cavity.

The intra-cooling device further includes: a liquid inlet formed in the top cap of the top insulating part, wherein the cooling liquid flows into the cavity through the liquid inlet, and a liquid outlet formed in the top cap of the top insulating part or in the bottom cap of the bottom insulating part, wherein the cooling liquid flows out of the cavity through the liquid outlet.

The intra-cooling device further includes one or both of: a first metal layer disposed on an outer surface of the top cap of the top insulating part for attaching a first chip; and a second metal layer disposed on an outer surface of the bottom cap of the bottom insulating part for attaching a second chip.

The at least one first heat conductor and the at least one second heat conductor include one or more of: a cylinder heat conductor, an elliptic cylinder heat conductor, a rectangular cylinder heat conductor, a regular polygonal cylinder heat conductor, an irregular cylinder heat conductor and a cone heat conductor; the attaching includes bonding together by sintering or welding using an electrically and/or thermally conductive material; the first chip and/or the second chip include a power chip; the first metal layer is formed on the outer surface of the top cap of the top insulating part by sintering, brazing, soldering or curing; and/or the second metal layer is formed on the outer surface of the bottom cap of the bottom insulating part by sintering, brazing, soldering or curing.

A power module comprising the intra-cooling device as defined above is provided.

The intra-cooling device of the power module comprises a first metal layer disposed on an outer surface of the top cap of the top insulating part and a second metal layer disposed on an outer surface of the bottom cap of the bottom insulating part; and the power module further comprises: a first chip attached on the first metal layer, the first chip being electrically coupled by the first metal layer and at least one of a conductive pillar, a conductive clip or a conductive wire; and a second chip attached on the second metal layer, the second chip being electrically coupled by the second metal layer and at least one of the conductive pillar, the conductive clip or the conductive wire; wherein the first metal layer and the second metal layer are further attached to a lead extending beyond the intra-cooling device.

An electrical system comprising the power module as defined above is provided.

A manufacturing method of an intra-cooling device for a power module is provided, comprising the following steps: forming a top insulating part by integrally fabricating, the top insulating part comprising: a top cap; and at least one first heat conductor disposed on an inner surface of the top cap and extending in a direction perpendicular to the inner surface of the top cap; forming a bottom insulating part by integrally fabricating, the bottom insulating part comprising: a box composed of a bottom cap and a plurality of sidewalls surrounding the bottom cap; and at least one second heat conductor disposed on an inner surface of the bottom cap and extending in a direction perpendicular to the inner surface of the bottom cap; and assembling the top insulating part and the bottom insulating part together in such a manner that the inner surface of the top cap and the inner surface of the bottom cap face each other, thereby forming a cavity capable of accommodating a cooling liquid.

The manufacturing method, further comprising performing, before assembling the top insulating part and the bottom insulating part together, one or both of the following steps: forming a first metal material layer on an outer surface of the top cap of the top insulating part and shaping the first metal material layer, thereby forming a first metal layer for attaching a first chip; and forming a second metal material layer on an outer surface of the bottom cap of the bottom insulating part and shaping the second metal material layer, thereby forming a second metal layer for attaching a second chip.

The manufacturing method, further comprising performing, before assembling the top insulating part and the bottom insulating part together, the following steps: forming a liquid inlet and a liquid outlet in the first metal layer and the top cap of the top insulating part; or forming a liquid inlet in the first metal layer and the top cap of the top insulating part, and forming a liquid outlet in the bottom cap of the bottom insulating part, wherein the cooling liquid flows into the cavity through the liquid inlet, and flows out of the cavity through the liquid outlet.

The at least one first heat conductor and the at least one second heat conductor are arranged in a staggered manner, such that respective heat conductors are spaced apart from each other by a certain distance in the cavity.

The plurality of sidewalls of the bottom insulating part are formed with sealing edges at their locations in contact with the top cap of the top insulating part, the sealing edges being capable of closely mating with edges of the top cap to seal the cavity.

The at least one first heat conductor and the at least one second heat conductor include one or more of: a cylinder heat conductor, an elliptic cylinder heat conductor, a rectangular cylinder heat conductor, a regular polygonal cylinder heat conductor, an irregular cylinder heat conductor and a cone heat conductor; the attaching comprises bonding together by sintering or welding using an electrically and/or thermally conductive material; the first chip and/or the second chip comprise a power chip; the first metal material layer is formed on the outer surface of the top cap of the top insulating part by sintering, brazing, soldering or curing; and/or the second metal material layer is formed on the outer surface of the bottom cap of the bottom insulating part by sintering, brazing, soldering or curing.

According to an embodiment, an intra-cooling device for a power module is provided, the intra-cooling device comprising:
a top insulating part, comprising a top cap, and at least one first heat conductor on an inner surface of the top cap and extending in a direction perpendicular to the inner surface of the top cap; and
a bottom insulating part, comprising a box composed of a bottom cap and a plurality of sidewalls surrounding the bottom cap, and at least one second heat conductor on an inner surface of the bottom cap and extending in a direction perpendicular to the inner surface of the bottom cap; and
a cavity capable for a cooling liquid formed by the inner surface of the top cap and the inner surface of the bottom cap facing each other.

According to an embodiment, the at least one first heat conductor and the at least one second heat conductor are arranged in a staggered manner, such that respective heat conductors are spaced apart from each other by a certain distance in the cavity.

According to an embodiment, the plurality of sidewalls of the bottom insulating part are formed with sealing edges at their locations in contact with the top cap of the top insulating part, the sealing edges being capable of closely mating with edges of the top cap to seal the cavity.

According to an embodiment, the intra-cooling device according further comprises a liquid inlet in the top cap of the top insulating part, wherein the cooling liquid flows into the cavity through the liquid inlet; and a liquid outlet in the top cap of the top insulating part or in the bottom cap of the bottom insulating part, wherein the cooling liquid flows out of the cavity through the liquid outlet.

According to an embodiment, the intra-cooling device further comprises at least one of a first metal layer on an outer surface of the top cap of the top insulating part for attaching a first chip; and a second metal layer on an outer surface of the bottom cap of the bottom insulating part for attaching a second chip.

According to an embodiment:
the at least one first heat conductor and the at least one second heat conductor include at least one of: a cylinder heat conductor, an elliptic cylinder heat conductor, a rectangular cylinder heat conductor, a regular polygonal cylinder heat conductor, an irregular cylinder heat conductor and a cone heat conductor;
the attaching comprises bonding;
the first chip or the second chip comprise a power chip;
the first metal layer is on the outer surface of the top cap of the top insulating part; and
the second metal layer is on the outer surface of the bottom cap of the bottom insulating part.

Another embodiment provides a power module comprising:
an intra-cooling device having a first opening on a top surface and a second opening on one of the top surface and a bottom surface;
a top cap;
a bottom cap coupled to the top cap, the bottom cap having a sidewall around an edge of the bottom cap, and the sidewall of the bottom cap has a sealing edge in contact with the top cap;
a cavity between the top cap and the bottom cap;
a first metal layer on an outer surface of the top cap;
a second metal layer on an outer surface of the bottom cap;
a plurality of first heat conductor fingers on the top cap and extending away from an inner surface of the top cap; and
a plurality of second heat conductor fingers on the bottom cap and extending away from an inner surface of the bottom cap toward and between the plurality of first heat conductor fingers, a distance between the sidewall and a first one of the second heat conductor fingers is wider than a size of the first opening.

According to an embodiment, the power module further comprises: a plurality of chips electrically coupled to at least one of the first metal layer and second metal layer; and a plurality of leads attached to at least one of the first metal layer and the second metal layer.

According to an embodiment, a first chip is on the first metal layer, the first chip being electrically coupled by the first metal layer and at least one of a conductive pillar, a conductive clip or a conductive wire; and a second chip is on the second metal layer, the second chip being electrically coupled by the second metal layer and at least one of the conductive pillar, the conductive clip or the conductive wire, the first metal layer and the second metal layer being further attached to a lead extending beyond the intra-cooling device.

According to an embodiment, the first opening and the second opening are centrally symmetric on the intra-cooling device.

According to an embodiment, the plurality of chips are centrally symmetric on the intra-cooling device.

According to an embodiment, the plurality of first heat conductor fingers have a shape from at least one from among a cylinder heat conductor, an elliptic cylinder heat conductor, a rectangular cylinder heat conductor, a regular polygonal cylinder heat conductor, an irregular cylinder heat conductor, and a cone heat conductor.

According to an embodiment, the plurality of first heat conductor fingers and the plurality of second heat conductor fingers are centrally symmetric manner on the intra-cooling device.

Another embodiment provides a method of manufacturing an intra-cooling device, comprising:
forming a top cap having a plurality of first heat conductor fingers on an inner surface of the top cap and extending away from an inner surface of the top cap;
forming a bottom cap having a plurality of second heat conductor fingers on an inner surface of the bottom cap and extending away from the inner surface of the bottom cap toward and
between the plurality of first heat conductor fingers, wherein a sidewall surrounds an edge of the bottom cap, and wherein a first space between an end of the first heat conductor fingers and a surface of the bottom cap is wider than a thickness of one of the plurality of first heat conductor fingers;
forming a first opening in one of the bottom cap and the top cap;
forming a second opening in one of the bottom cap and the top cap;
forming a cavity by assembling the top cap and the bottom cap to have the inner surface of the top cap and the inner surface of the bottom cap face each other.

According to an embodiment, the method further comprises:
coupling a first metal layer on an outer surface of the top cap, the first metal layer being configured to couple a first chip; and
coupling a second metal layer on an outer surface of the bottom cap, the second metal layer being configured to couple a second chip.

According to an embodiment, a cooling liquid is configured to flow into the cavity through the first opening, and flows out of the cavity through the second opening.

According to an embodiment, the plurality of first heat conductor fingers and the plurality of second heat conductor fingers are centrally symmetric on the intra-cooling device.

According to an embodiment, the method comprises arranging the first chip and the second chip centrally symmetric on the intra-cooling device.

According to an embodiment, the sidewall of the bottom cap is formed with sealing edges of the bottom cap in contact with the top cap, the sealing edges being configured to closely mate with edges of the top cap.

According to an embodiment:
the plurality of first heat conductor fingers and the plurality of second heat conductor fingers include at least one of: a cylinder heat conductor, an elliptic cylinder heat conductor, a rectangular cylinder heat conductor, a regular polygonal cylinder heat conductor, an irregular cylinder heat conductor and a cone heat conductor;
at least one of the first chip and the second chip comprise a power chip;
the first metal layer is formed on the outer surface of the top cap by sintering, brazing, soldering or curing; and
the second metal layer is formed on the outer surface of the bottom by sintering, brazing, soldering or curing.

The various embodiments described above can be combined to provide further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. An intra-cooling device for a power module, the intra-cooling device comprising:
a top insulating part, comprising:
a top cap, and
at least one first heat conductor on an inner surface of the top cap and extending in a direction perpendicular to the inner surface of the top cap; and
a bottom insulating part, comprising:
a box composed of a bottom cap and a plurality of sidewalls surrounding the bottom cap, and
at least one second heat conductor on an inner surface of the bottom cap and extending in a direction perpendicular to the inner surface of the bottom cap,
a cavity capable for a cooling liquid formed by the inner surface of the top cap and the inner surface of the bottom cap facing each other.

2. The intra-cooling device according to claim 1, wherein the at least one first heat conductor and the at least one second heat conductor are arranged in a staggered manner, such that respective heat conductors are spaced apart from each other by a certain distance in the cavity.

3. The intra-cooling device according to claim 1 or 2, wherein the plurality of sidewalls of the bottom insulating part are formed with sealing edges at their locations in contact with the top cap of the top insulating part, the sealing edges being capable of closely mating with edges of the top cap to seal the cavity.

4. The intra-cooling device according to any of claims 1 to 3, further comprising:
a liquid inlet in the top cap of the top insulating part, wherein the cooling liquid flows into the cavity through the liquid inlet; and
a liquid outlet in the top cap of the top insulating part or in the bottom cap of the bottom insulating part, wherein the cooling liquid flows out of the cavity through the liquid outlet.

5. The intra-cooling device according to any of claims 1 to 4, further comprising at least one of:
a first metal layer on an outer surface of the top cap of the top insulating part for attaching a first chip; and
a second metal layer on an outer surface of the bottom cap of the bottom insulating part for attaching a second chip.

6. The intra-cooling device according to claim 5, wherein:
the at least one first heat conductor and the at least one second heat conductor include at least one of: a cylinder heat conductor, an elliptic cylinder heat conductor, a rectangular cylinder heat conductor, a regular polygonal cylinder heat conductor, an irregular cylinder heat conductor and a cone heat conductor;
the attaching comprises bonding;
the first chip or the second chip comprise a power chip;
the first metal layer is on the outer surface of the top cap of the top insulating part; and
the second metal layer is on the outer surface of the bottom cap of the bottom insulating part.

7. A power module comprising an intra-cooling device according to any of claims 1 to 6, the intro-cooling device having a first opening on a top surface and a second opening on one of the top surface and a bottom surface, wherein the at least one first heat conductor comprises a plurality of first heat conductor fingers on the top cap and extending away from an inner surface of the top cap, and the at least one second heat conductor comprises a plurality of second heat conductor fingers on the bottom cap and extending away from an inner surface of the bottom cap toward and between the plurality of first heat conductor fingers, a distance between the sidewall and a first one of the second heat conductor fingers is wider than a size of the first opening.

8. The power module according to claim 7 depending from claim 5, wherein:
A) the power module further comprises a plurality of chips electrically coupled to at least one of the first metal layer and second metal layer, and a plurality of leads attached to at least one of the first metal layer and the second metal layer, the plurality of chips being preferably centrally symmetric on the intra-cooling device ; or
B) a first chip is on the first metal layer, the first chip being electrically coupled by the first metal layer and at least one of a conductive pillar, a conductive clip or a conductive wire, and a second chip is on the second metal layer, the second chip being electrically coupled by the second metal layer and at least one of the conductive pillar, the conductive clip or the conductive wire, wherein the first metal layer and the second metal layer are further attached to a lead extending beyond the intra-cooling device.

9. The power module according to claim 7 or 8, wherein the first opening and the second opening are centrally symmetric on the intra-cooling device.

10. A method of manufacturing an intra-cooling device according to any of claims 1 to 6, comprising:
forming the top cap having a plurality of first heat conductor fingers on an inner surface of the top cap and extending away from an inner surface of the top cap;
forming the bottom cap having a plurality of second heat conductor fingers on an inner surface of the bottom cap and extending away from the inner surface of the bottom cap toward and between the plurality of first heat conductor fingers, wherein the sidewall surrounds an edge of the bottom cap, and wherein a first space between an end of the first heat conductor fingers and a surface of the bottom cap is wider than a thickness of one of the plurality of first heat conductor fingers;
forming a first opening in one of the bottom cap and the top cap;
forming a second opening in one of the bottom cap and the top cap;
forming the cavity by assembling the top cap and the bottom cap to have the inner surface of the top cap and the inner surface of the bottom cap face each other.

11. The method according to claim 10, further comprising:
coupling a first metal layer on an outer surface of the top cap, the first metal layer being configured to couple a first chip; and
coupling a second metal layer on an outer surface of the bottom cap, the second metal layer being configured to couple a second chip,
wherein, preferably the first chip and the second chip are arranged centrally symmetric on the intra-cooling device.

12. The method according to claim 10 or 11, wherein a cooling liquid is configured to flow into the cavity through the first opening, and flows out of the cavity through the second opening.

13. The method according to any of claims 10-12 or the power module according to any of claims 7-9, wherein the plurality of first heat conductor fingers and the plurality of second heat conductor fingers are centrally symmetric on the intra-cooling device.

14. The method according to any of claims 10-13, wherein:
the sidewall of the bottom cap is formed with sealing edges of the bottom cap in contact with the top cap, the sealing edges being configured to closely mate with edges of the top cap.

15. The method according to claim 11, wherein:
the plurality of first heat conductor fingers and the plurality of second heat conductor fingers include at least one of: a cylinder heat conductor, an elliptic cylinder heat conductor, a rectangular cylinder heat conductor, a regular polygonal cylinder heat conductor, an irregular cylinder heat conductor and a cone heat conductor;
at least one of the first chip and the second chip comprise a power chip;
the first metal layer is formed on the outer surface of the top cap by sintering, brazing, soldering or curing; and
the second metal layer is formed on the outer surface of the bottom by sintering, brazing, soldering or curing.
